# FASCICULE DE BREVET EUROPEEN

(11) **EP 3 258 569 B1**
(45) Date de publication et mention de la délivrance du brevet: **27.12.2023**
(21) Numéro de dépôt: 17175553.1
(22) Date de dépôt: 12.06.2017
(51) Int. Cl.: H02J 7/00, H02J 9/06, H03K 19/0185

(54) **SYSTÈME D'ALIMENTATION COMPRENANT UNE UNITÉ DE GESTION PRINCIPALE ET UNE UNITÉ DE GESTION DE RÉSERVE**
STROMVERSORGUNGSSYSTEM, DAS EINE HAUPTSTEUEREINHEIT UND EINE RESERVESTEUEREINHEIT UMFASST
POWER SUPPLY SYSTEM COMPRISING A MAIN MANAGEMENT UNIT AND A RESERVE MANAGEMENT UNIT

(30) Priorité: 13.06.2016 FR 1655461
(43) Date de publication de la demande: 20.12.2017
(73) Titulaire: Sagemcom Energy & Telecom SAS, 92270 Bois-Colombes (FR)
(72) Inventeur: WEBER, Patrick, 92500 RUEIL MALMAISON (FR)
(74) Mandataire: Lavaud, Thomas

(56) Documents cités:
- US-A1- 2013 002 204
- US-A1- 2013 007 336

## Description

L'invention concerne le domaine de l'alimentation d'équipements électriques.

### ARRIERE PLAN DE L'INVENTION

Certains équipements électriques, alimentés normalement par une source d'alimentation principale, comportent ou sont reliés à des moyens de stockage d'énergie destinés à pallier une défaillance limitée dans le temps de la source d'alimentation principale. Les moyens de stockage d'énergie comportent par exemple une supercapacité ou une batterie qui est chargée par la source d'alimentation principale lorsque celle-ci est disponible, et qui est déchargée pour suppléer ponctuellement la source d'alimentation principale lorsque celle-ci est indisponible.

Ainsi, un concentrateur de données de consommation de gaz comporte un module électrique alimenté normalement par une source d'alimentation principale (en l'occurrence, par le secteur) et, en cas de coupure du secteur, par des moyens de stockage d'énergie. Un tel concentrateur de données de consommation de gaz est situé par exemple sur le toit d'un immeuble et est destiné à recevoir et à retransmettre, grâce à des moyens de communication sans fil agencés dans le module électrique, des données de consommation de gaz produites par une pluralité de compteurs de gaz. On note que les moyens de stockage d'énergie sont possiblement situés à une certaine distance du module électrique.

Il semble intéressant de surveiller la charge et la décharge des moyens de stockage d'énergie depuis le module électrique. On peut, grâce à une telle surveillance, protéger les moyens de stockage d'énergie de phénomènes susceptibles de les dégrader, par exemple d'un phénomène de surdécharge d'une supercapacité ou d'une batterie. On peut aussi anticiper une décharge complète des moyens de stockage d'énergie, susceptible d'éteindre brutalement le module électrique, en éteignant proprement le module électrique avant que cette décharge complète ne survienne.

Il convient bien sûr de simplifier au maximum et de réduire les coûts de la mise en oeuvre de cette surveillance.

Le document US 2013/007336 A1 divulgue un système destiné à recharger la batterie d'un appareil à partir d'un autre appareil comportant une source d'énergie, les deux appareils étant reliés par une interface dont la connexion est détectée et utilisée comme condition pour activer un circuit de recharge.

Le document US 2013/002204 A1 divulgue un système employant une communication analogue d'une unité de gestion de réserve vers une unité de gestion principale.

### OBJET DE L'INVENTION

L'invention a pour objet de simplifier et de réduire les coûts de la surveillance de la charge et de la décharge de moyens de stockage d'énergie, ladite surveillance étant réalisée depuis un module électrique possiblement situé à une certaine distance des moyens de stockage d'énergie.

### RESUME DE L'INVENTION

En vue de la réalisation de ce but, on propose un système d'alimentation comprenant une unité de gestion principale destinée à être reliée à une source d'alimentation principale et une unité de gestion de réserve destinée à être reliée à des moyens de stockage d'énergie, l'unité de gestion principale et l'unité de gestion de réserve étant agencées pour être reliées l'une à l'autre par un fil de tension haute, un fil de tension basse et un fil de contrôle. L'unité de gestion principale comporte des moyens d'application adaptés à appliquer sélectivement une tension haute sur le fil de contrôle ou une tension basse sur le fil de contrôle pour transmettre à l'unité de gestion de réserve un signal d'activation de décharge ou un signal de désactivation de décharge. L'unité de gestion de réserve comportant des moyens de charge adaptés à charger les moyens de stockage d'énergie via le fil de tension haute et le fil de tension basse, et des moyens de décharge adaptés à décharger les moyens de stockage d'énergie via le fil de tension haute et le fil de tension basse lorsque l'unité de gestion de réserve reçoit le signal d'activation de décharge et à stopper la décharge lorsque l'unité de gestion de réserve reçoit le signal de désactivation de décharge.

L'unité de gestion principale est ainsi adaptée à gérer, via l'unité de gestion de réserve, la décharge des moyens de stockage d'énergie, et donc à réaliser une surveillance desdits moyens de stockage d'énergie.

L'unité de gestion principale peut notamment être positionnée sur ou à proximité d'un module électrique tel que celui évoqué plus tôt, alors que l'unité de gestion secondaire peut être positionnée à une certaine distance de l'unité de gestion principale et à proximité des moyens de stockage d'énergie.

Seuls trois fils relient l'unité de gestion principale et l'unité de gestion de réserve du système d'alimentation, ce qui limite l'encombrement et simplifie l'intégration du système d'alimentation selon l'invention.

Enfin, on note que l'unité de gestion principale et l'unité de gestion de réserve communiquent de manière purement analogique, via l'application de tensions analogiques (la tension haute et la tension basse) sur le fil de contrôle. La communication entre l'unité de gestion principale et l'unité de gestion de réserve ne nécessite donc pas de composants numériques complexes, tels qu'un processeur, ce qui réduit la complexité et le coût de cette communication et donc du système d'alimentation selon l'invention.

On propose aussi une unité de gestion principale et une unité de gestion de réserve.

L'invention sera mieux comprise à la lumière de la description qui suit d'un mode de mise en oeuvre particulier non limitatif de l'invention.

### BREVE DESCRIPTION DES DESSINS

Il sera fait référence aux dessins annexés, parmi lesquels :
- la figure 1 est un schéma électrique du système d'alimentation selon l'invention ;
- la figure 2 représente un connecteur monté sur l'unité de gestion principale et sur l'unité de gestion de réserve ;
- la figure 3 est un schéma électrique d'un gestionnaire d'état de l'unité de gestion de réserve ;
- la figure 4 est un graphique comportant des courbes de tension illustrant le fonctionnement du système d'alimentation selon l'invention.

### DESCRIPTION DETAILLEE DE L'INVENTION

Le système d'alimentation selon l'invention est ici utilisé pour alimenter électriquement un concentrateur de données de consommation de gaz, mais pourrait bien sûr être utilisé pour alimenter tout autre type d'équipement électrique, de système électrique ou d'installation électrique.

Le concentrateur comporte un module électrique qui comprend notamment des moyens de communication sans fil destinés à recevoir des données de consommation de gaz produites par une pluralité de compteurs de gaz et à envoyer les données de consommation de gaz à un système d'information du fournisseur de gaz.

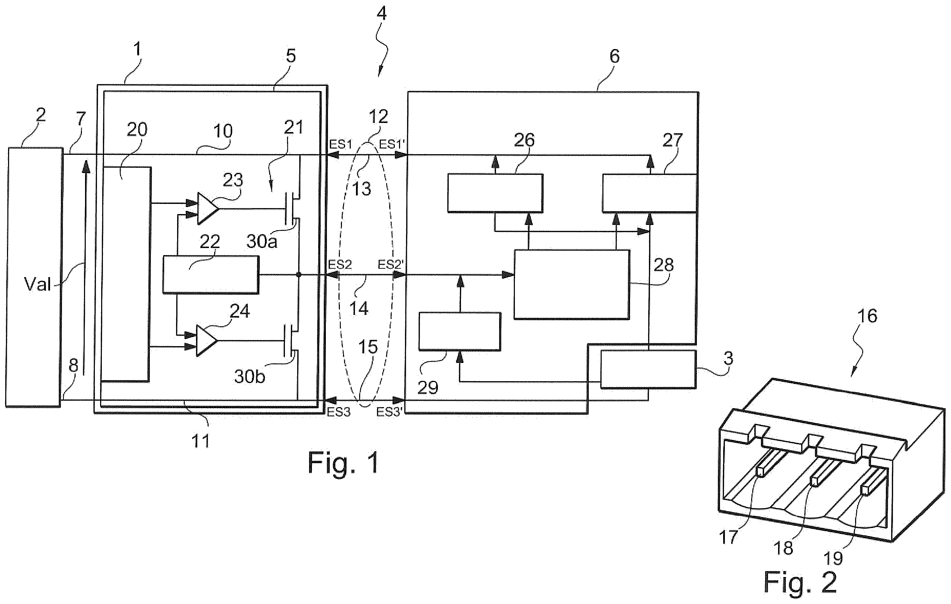

En référence à la figure 1, le module électrique 1 est alimenté normalement par une source d'alimentation principale 2 délivrant une énergie d'alimentation sous une tension d'alimentation principale Val, le secteur en l'occurrence, et, en cas de défaillance limitée dans le temps de la source d'alimentation principale 2 (par exemple, en cas de coupure ou de chute de tension du secteur), par des moyens de stockage d'énergie 3 situés à une certaine distance du module électrique 1. Par « une certaine distance », on entend une distance comprise entre quelques centimètres et quelques dizaines de mètres. Les moyens de stockage d'énergie 3 comprennent ici une supercapacité.

Le système d'alimentation selon l'invention, désigné en 4, comporte une unité de gestion principale 5 et une unité de gestion de réserve 6.

L'unité de gestion principale 5 est agencée sur le module électrique 1 (c'est-à-dire que les composants de l'unité de gestion principale 5 sont montés sur une carte électrique du module électrique 1), alors que l'unité de gestion de réserve 6 est positionnée à proximité immédiate des moyens de stockage d'énergie 3. L'unité de gestion de réserve 6 est donc située à une certaine distance de l'unité de gestion principale 5.

L'unité de gestion principale 5 est reliée par un fil d'alimentation 7 et par un fil de masse 8 à la source d'alimentation principale 2. L'unité de gestion principale 5 comprend une référence de tension d'alimentation 10 et une référence de masse 11. La référence de tension d'alimentation 10 est reliée au fil d'alimentation 7 et la référence de masse 11 est reliée au fil de masse 8.

L'unité de gestion principale 5 et l'unité de gestion de réserve 5 sont reliées entre elles par un câble 12 comprenant trois fils uniquement : un fil de tension haute 13, un fil de contrôle 14 et un fil de tension basse 15. Le fil de tension haute 13 est relié à la référence de tension d'alimentation 10 de l'unité de gestion principale 5 et le fil de tension basse 15 est relié à la référence de masse 11 de l'unité de gestion principale 5. L'unité de gestion principale 5 et l'unité de gestion de réserve 6 comportent chacune un connecteur tel que le connecteur 16, visible sur la figure 2, qui comporte trois broches : une première broche 17 à laquelle est connectée une extrémité du fil de tension haute 13, une deuxième broche 18 à laquelle est connectée une extrémité du fil de contrôle 14, et une troisième broche 19 à laquelle est connectée une extrémité du fil de tension basse 15.

L'unité de gestion principale 5 comporte un module de commande 20, des moyens d'application 21, des moyens de surveillance 22, un premier comparateur 23 et un deuxième comparateur 24.

L'unité de gestion de réserve 6 comporte des moyens de charge 26, des moyens de décharge 27, des moyens de gestion 28 et des moyens de conversion 29.

Lorsque le concentrateur démarre et que le module électrique 1 et l'unité de gestion principale 5 sont mis sous tension, le module électrique 1 et l'unité de gestion principale 5 sont alimentés par la source d'alimentation principale 2 (c'est-à-dire, par l'énergie d'alimentation délivrée sous la tension d'alimentation principale Val via le fil d'alimentation 7 et le fil de masse 8).

L'unité de gestion de réserve 6 est ensuite à son tour alimentée par la source d'alimentation principale 2, via l'unité de gestion principale 5 et via le fil de tension haute 13 et le fil de tension basse 15. Les moyens de charge 26 de l'unité de gestion de réserve 6 démarrent alors une charge des moyens de stockage d'énergie 3 grâce à une portion de l'énergie d'alimentation disponible pour la charge et cheminant via le fil de tension haute 13 et le fil de tension basse 15.

On note que la charge des moyens de stockage d'énergie 3 ne démarre pas instantanément au démarrage du module électrique 1 et de l'unité de gestion principale 5, pour éviter un pic de consommation au démarrage.

Les moyens de conversion 29 de l'unité de gestion de réserve 6 convertissent un niveau de charge des moyens de stockage d'énergie 3 en une tension de niveau de charge Vnc. Les moyens de conversion 29 appliquent la tension de niveau de charge Vnc sur le fil de contrôle 14.

Les moyens de surveillance 22 de l'unité de gestion principale 5, reliés au fil de contrôle 14, détectent la présence de la tension de niveau de charge Vnc sur le fil de contrôle 14 et donc la présence de l'unité de gestion de réserve 6 et des moyens de stockage d'énergie 3.

Les moyens de surveillance 22 de l'unité de gestion principale 5 surveillent alors, grâce à la tension de niveau de charge, la charge des moyens de stockage 3.

Les moyens de gestion 28 de l'unité de gestion de réserve 6 comportent un gestionnaire d'état. Le gestionnaire d'état gère un état logique des moyens de stockage d'énergie 3, représentatif d'un état de charge et d'un état de décharge des moyens de stockage d'énergie 3. Le gestionnaire d'état fait passer, au moment du démarrage de la charge, l'état logique des moyens de stockage d'énergie 3 d'un état « arrêt » à un état « charge », et mémorise l'état logique des moyens de stockage d'énergie 3.

Le module électrique 1 ne démarre aucune fonction sensible (par exemple, une modification d'informations en mémoire flash) tant que les moyens de stockage d'énergie 3 ne sont pas complètement chargés. On assure ainsi qu'en cas de coupure de la source d'alimentation principale 2, les moyens de stockage d'énergie 3 sont capables de pallier la coupure de la source d'alimentation principale 2 et de permettre à la fonction sensible d'être menée à son terme ou bien d'être stoppée avant même d'être lancée (pour éviter par exemple une corruption de données).

Lorsqu'une défaillance de la source d'alimentation principale 2 survient, la tension d'alimentation principale Val chute. Si cette chute est trop importante, la source d'alimentation principale 2 n'est plus en mesure d'alimenter correctement le module électrique 1, et il convient alors de décharger les moyens de stockage d'énergie 3 pour que l'énergie stockée dans les moyens de stockage d'énergie 3 alimente le module électrique 1.

Le premier comparateur 23, qui compare en permanence la référence de tension d'alimentation 10 (et donc la tension d'alimentation principale Val) avec un seuil de tension d'alimentation prédéterminé, commande les moyens d'application 21 pour que ceux-ci transmettent un signal d'activation de décharge à l'unité de gestion de réserve 6.

Le seuil de tension d'alimentation prédéterminé correspond à un niveau de tension de la source d'alimentation principale 2 en dessous duquel la source d'alimentation principale 2 n'est plus en mesure d'alimenter correctement le module électrique 1, et donc en dessous duquel il convient de décharger les moyens de stockage d'énergie 3 pour alimenter le module électrique 1.

Les moyens d'application 21 comprennent des composants de connexion qui sont adaptés à connecter sélectivement au fil de contrôle 14 la référence de tension d'alimentation 10 de l'unité de gestion principale 5 et/ou la référence de masse 11 de l'unité de gestion principale 5. Les composants de connexion comportent des composants à base de semiconducteurs, et notamment deux transistors 30a, 30b de type MOSFET. Le transistor 30a permet de connecter sélectivement au fil de contrôle 14 la référence de tension d'alimentation 10. Le transistor 30b permet de connecter sélectivement au fil de contrôle 14 la référence de tension de masse 11.

La transmission du signal d'activation de décharge à l'unité de gestion de réserve 6 consiste à connecter ponctuellement, pendant une très courte durée, la référence de tension d'alimentation 10 au fil de contrôle 14, et donc à appliquer une impulsion de tension haute égale à la référence de tension d'alimentation 10. Le transistor 30a des moyens d'application 21 est utilisé pour connecter la référence de tension d'alimentation 10 au fil de contrôle 14. La tension sur le fil de contrôle 14 est donc égale à l'impulsion de tension haute.

Les moyens de gestion 28 de l'unité de gestion de réserve 6, qui sont reliés au fil de contrôle 14, reçoivent l'impulsion de tension haute et donc le signal d'activation de décharge.

Les moyens de gestion 28 commandent alors les moyens de décharge 27 de l'unité de gestion de réserve 6, qui déchargent alors les moyens de stockage d'énergie 3 et transmettent l'énergie stockée dans les moyens de stockage d'énergie 3 au module électrique 1 via le fil de tension haute 13, le fil de tension basse 15 et l'unité de gestion principale 5.

Le gestionnaire d'état fait passer l'état logique des moyens de stockage d'énergie 3 de l'état « charge » à un état « décharge », et mémorise l'état logique des moyens de stockage d'énergie 3.

Les moyens de surveillance 22 de l'unité de gestion principale 5, reliés au fil de contrôle 14, surveillent alors, grâce à la tension de niveau de charge, la décharge des moyens de stockage 3.

Les moyens de surveillance 22 acquièrent à cet effet la tension de niveau de charge Vnc et la transmettent au deuxième comparateur 24. Pendant toute la décharge, le deuxième comparateur 24 compare en permanence la tension de niveau de charge Vnc avec un seuil de tension de charge prédéterminé. Lorsque la tension de niveau de charge Vnc est inférieure ou égale au seuil de tension de charge prédéterminé, le deuxième comparateur 24 commande les moyens d'application 21 pour que ceux-ci transmettent un signal de désactivation de décharge à l'unité de gestion de réserve 6.

Le seuil de tension de charge prédéterminé correspond à un niveau de surdécharge de la supercapacité des moyens de stockage d'énergie 3. Lorsque ce niveau est atteint, il convient de stopper la décharge des moyens de stockage d'énergie 3, sans quoi la supercapacité risque d'être endommagée.

Le passage sous le seuil de tension de charge prédéterminé constitue une première source de désactivation de la décharge.

Les moyens de surveillance 22 comportent de plus un dispositif de mesure de durée de la décharge, qui désactive la décharge lorsque la durée de celle-ci dépasse une durée prédéterminée. La durée prédéterminée est définie en tenant compte du fait que la supercapacité doit conserver une partie de sa charge.

Le dispositif de mesure de durée de la décharge constitue une deuxième source de désactivation de la décharge.

Les moyens de surveillance 22 comportent en outre un dispositif pour générer un signal de fin de décharge dans le but de sauvegarder des informations. Le signal de fin de décharge désactive la décharge avant que le seuil de tension de charge prédéterminé ne soit atteint.

Le dispositif pour générer un signal de fin de décharge constitue une troisième source de désactivation de la décharge.

La transmission du signal de désactivation de décharge à l'unité de gestion de réserve 6 consiste à connecter ponctuellement, pendant une très courte durée, la référence de masse 11 au fil de contrôle 14, et donc à appliquer une impulsion de tension basse égale à la référence de masse 11. Le transistor 30b des moyens d'application 21 est utilisé pour connecter la référence de masse 11 au fil de contrôle 14. La tension sur le fil de contrôle 14 est donc égale à l'impulsion de tension basse.

Les moyens de gestion 28 de l'unité de gestion de réserve 6, qui sont reliés au fil de contrôle 14, reçoivent l'impulsion de tension basse et donc le signal de désactivation de décharge.

Les moyens de gestion 28 commandent alors les moyens de décharge 27 de l'unité de gestion de réserve 6, qui stoppent la décharge des moyens de stockage d'énergie 3.

Le gestionnaire d'état fait passer l'état logique des moyens de stockage d'énergie 3 de l'état « décharge » à l'état « arrêt », et mémorise l'état logique des moyens de stockage d'énergie 3.

A cet instant, la source d'énergie principale 2 et les moyens de stockage d'énergie 3 ne sont donc plus en mesure d'alimenter le module électrique 1, l'unité de gestion principale 5 et l'unité de gestion de réserve 6.

Les moyens de commande 20 de l'unité de gestion principale 5 commandent alors une extinction propre du module électrique 1 (et donc de l'unité de gestion principale 5). Par « extinction propre », on entend notamment que les caractéristiques de la tension d'alimentation du module électrique 1 lors de son extinction correspondent à des caractéristiques spécifiées, mais aussi que certaines fonctions réalisées par le module électrique 1 (par exemple, comme indiqué plus tôt, une modification d'informations en mémoire flash) sont soit stoppées soit annulées de manière à éviter toute corruption de données.

Seul un retour de la tension d'alimentation principale Val de la source d'alimentation principale 2 peut redémarrer le module électrique 1 et l'unité de gestion principale 5. Lorsque le retour de la tension d'alimentation principale Val se produit, les moyens de charge 26 de l'unité de gestion de réserve 6 démarrent par défaut une charge des moyens de stockage d'énergie 3, et le gestionnaire d'état fait passer l'état logique des moyens de stockage d'énergie 3 d'un état « arrêt » à un état « charge », et mémorise l'état logique des moyens de stockage d'énergie 3.

Avantageusement, les moyens de surveillance 22 de l'unité de gestion principale 5 réalisent un filtrage passe-bas de la tension de niveau de charge Vnc sur le fil de contrôle 14. Le niveau de tension de niveau de charge Vnc est ainsi acquis de manière plus précise pour réaliser la surveillance de la charge et de la décharge des moyens de stockage d'énergie 3.

Avantageusement encore, les moyens de commande 20 de l'unité de gestion principale 5 sont aussi adaptés à interrompre la charge lorsque toute l'énergie d'alimentation disponible provenant de la source d'alimentation principale 2 doit être utilisée pour alimenter le module électrique 1 et réaliser des opérations en cours, et non pour charger les moyens de stockage d'énergie 3.

On fournit maintenant quelques exemples de caractéristiques électriques des entrées/sorties de l'unité de gestion principale 5 et de l'unité de gestion de réserve 6 reliées au fil de tension haute 13, au fil de contrôle 14 et au fil de tension basse 15. On nomme ES1, ES2, ES3 les entrées/sorties de l'unité de gestion principale 5 connectées respectivement au fil de tension haute 13, au fil de contrôle 14 et au fil de masse 15. On nomme ES1' , ES2', ES3' les entrée/sortie de l'unité de gestion de réserve 6 connectées respectivement au fil de tension haute 13, au fil de contrôle 14 et au fil de masse 15.

Au cours d'une charge des moyens de stockage d'énergie 3, ES1 est une sortie de puissance et ES1' une entrée de puissance (c'est à dire que la puissance circule depuis ES1 vers ES1'). La tension au niveau de ES1 est classiquement comprise entre 10,2V et 17V, et un courant maximal circulant depuis ES1 vers ES1' est classiquement égal à 0,1A.

Au cours d'une décharge des moyens de stockage d'énergie 3, ES1 est une entrée de puissance et ES1' une sortie de puissance. La tension au niveau de ES1' est classiquement égale à 10V, et un courant maximal circulant depuis ES1' vers ES1 est classiquement égal à 2,5A.

On note ici que l'unité de gestion principale 5 fonctionne indépendamment de la tension de charge et de décharge des moyens de stockage d'énergie 3, et de la tension sur ES1' appliquée par l'unité de gestion de réserve 6 lors de la décharge des moyens de stockage d'énergie 3. L'unité de gestion principale 5 est donc compatible avec différentes conceptions de l'unité de gestion secondaire 6 et des moyens de stockage d'énergie 3 susceptibles de fonctionner, en charge et en décharge, sous différentes tensions pouvant varier sur une étendue relativement importante.

Lorsque l'unité de gestion principale 5 n'est pas connectée à une unité de gestion de réserve 6 (et réciproquement), aucune tension n'est présente sur ES1 et sur ES1', pour éviter tout danger électrique.

Lorsque l'unité de gestion principale 5 n'est plus connectée à une unité de gestion de réserve 6, ES2 est portée à très haute impédance à 3.3V (ici, à 470kQ). L'unité de gestion de réserve 6, quant à elle, s'éteint rapidement faute de tension d'alimentation via ES1' et ES3' .

Lorsque l'unité de gestion principale 5 et l'unité de gestion de réserve 6 sont connectées, ES2 est en haute impédance à 3,3V (la haute impédance est ici à 47kΩ). ES2' est une sortie sur laquelle est appliquée la tension de niveau de charge Vnc, qui est comprise entre 1,2V et 3,3V.

Lorsqu'un signal d'activation de décharge est transmis, une impulsion de tension haute, d'une durée de 10ms, est émise sur le fil de contrôle 14. La tension de ES2 est donc égale, pendant 10ms, à la tension haute (soit, ici, à la référence de tension d'alimentation 10 et donc à la tension d'alimentation principale Val). La tension haute est aussi appliquée sur ES2'. La décharge est commandée par les moyens de gestion 28 lorsque la tension sur ES2' est supérieure à 5V.

Lorsqu'un signal de désactivation de décharge est transmis, une impulsion de tension basse, d'une durée de 10ms, est émise sur le fil de contrôle 14. La décharge est alors stoppée par les moyens de gestion 28 de l'unité de gestion de réserve.

Enfin, ES3 est reliée à la référence de masse 11, et ES3' est reliée à une référence de masse de l'unité de gestion de réserve 6.

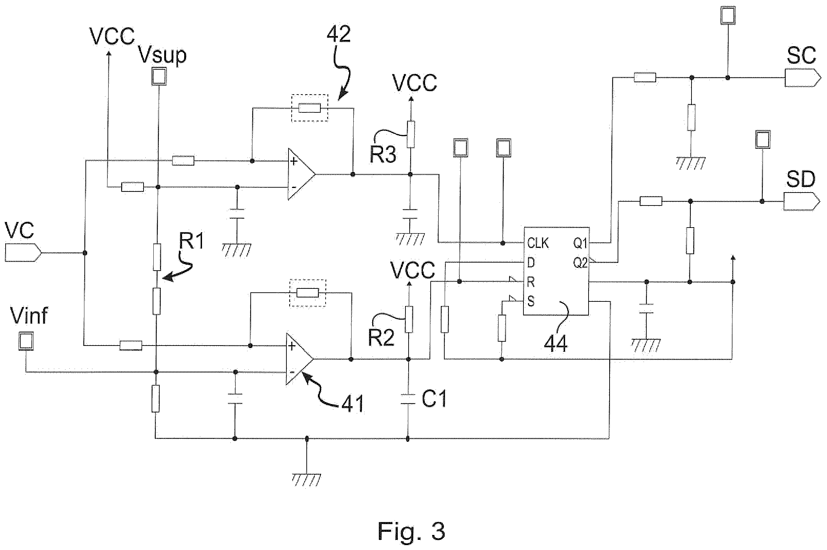

On décrit maintenant, en référence à la figure 3, le gestionnaire d'état des moyens de gestion 28 de l'unité de gestion de réserve 6.

Le gestionnaire d'état est mis en oeuvre par un circuit électrique 40 présentant trois entrées et deux sorties. Les entrées comprennent une tension de contrôle Vc miroir de la tension de niveau de charge Vnc, une tension de référence inférieure Vinf et une tension de référence supérieure Vsup. La tension de référence inférieure Vinf et la tension de référence supérieure Vsup sont obtenues par division de tension d'une tension Vcc grâce à des résistances R1. Les sorties comprennent une sortie de charge SC et une sortie de décharge SD. Un niveau haut sur la sortie de charge SC commande une charge des moyens de stockage 3, et un niveau haut sur la sortie de décharge SD commande une décharge des moyens de stockage 3.

Le circuit électrique 40 comporte un troisième comparateur 41, un quatrième comparateur 42 et une bascule D 44.

Le troisième comparateur 41 compare la tension de contrôle Vc avec la tension de référence inférieure Vinf. Le quatrième comparateur 42 compare la tension de contrôle Vc avec la tension de référence supérieure Vsup.

La bascule D 44, qui mémorise l'état logique des moyens de stockage d'énergie 3, comporte une entrée horloge CLK, une entrée set inversée S, une entrée reset inversée R, une entrée de signal D, une sortie Q1 et une sortie inversée Q2.

La sortie du troisième comparateur 41 est reliée à l'entrée reset inversée R de la bascule D 44. Une résistance de tirage R2 (ou « pull-up » en anglais), reliée à la tension Vcc, permet de produire un niveau haut à partir de la sortie du troisième comparateur 41.

La sortie du quatrième comparateur 42 est reliée à l'entrée horloge CLK. Une résistance de tirage R3 (ou « pull-up » en anglais) permet de produire un niveau haut à partir de la sortie du quatrième comparateur 42.

La sortie set inversée S de la bascule D 44 est reliée à la tension Vcc.

Une capacité C1, reliée à la résistance de tirage R2, permet de générer un reset plus long que le set de la bascule D 44 à la mise sous tension. On active le système de charge.

Lorsque la tension de contrôle Vc est inférieure à la tension de référence inférieure Vinf, la bascule D 44 est resetée (il faut en effet un niveau bas sur l'entrée R de la bascule D 44 pour activer le reset), un niveau haut est appliqué sur la sortie de charge SC, un niveau bas est appliqué sur la sortie de décharge SD, et la charge démarre. L'état logique des moyens de stockage d'énergie 3 est dans l'état « charge ».

Lorsque la tension de contrôle Vc dépasse la tension de référence supérieure Vsup, ce qui signifie qu'une impulsion de tension haute est détectée sur le fil de contrôle 14 et donc qu'un signal d'activation de décharge est transmis, la bascule D 44 est activée, un niveau bas est appliqué sur la sortie de charge SC, un niveau haut est appliqué sur la sortie de décharge SD, la charge est stoppée et la décharge débute. L'état logique des moyens de stockage d'énergie 3 est dans l'état « décharge ».

A la fin de la décharge, la tension de contrôle Vc devient inférieure à la tension de référence inférieure Vinf, ce qui signifie qu'une impulsion de tension basse est détectée sur le fil de contrôle 14 et donc qu'un signal de désactivation de décharge est transmis. Un niveau haut est appliqué sur la sortie de charge SC, un niveau bas est appliqué sur la sortie de décharge SD, ce qui interrompt l'alimentation de l'unité de gestion de réserve 6. L'état logique des moyens de stockage d'énergie 3 est dans l'état « arrêt ».

Au retour de l'alimentation de la source principale, la bascule D 44 est resetée et remise en charge (par défaut).

Enfin, lorsque l'unité de gestion de réserve 6 n'est plus connectée à l'unité de gestion principale 5, l'unité de gestion de réserve 6 maintient la tension de contrôle Vc sous la tension de référence supérieure Vsup, et donc la charge est activée. L'absence de tension d'alimentation stoppe rapidement le troisième comparateur 41 et le quatrième comparateur 42, et laisse la tension de contrôle Vc à la masse. L'unité de gestion de réserve 6 est donc stoppée dans un statut connu (de charge) qui empêche toute décharge ou fuite d'énergie des moyens de stockage d'énergie 3.

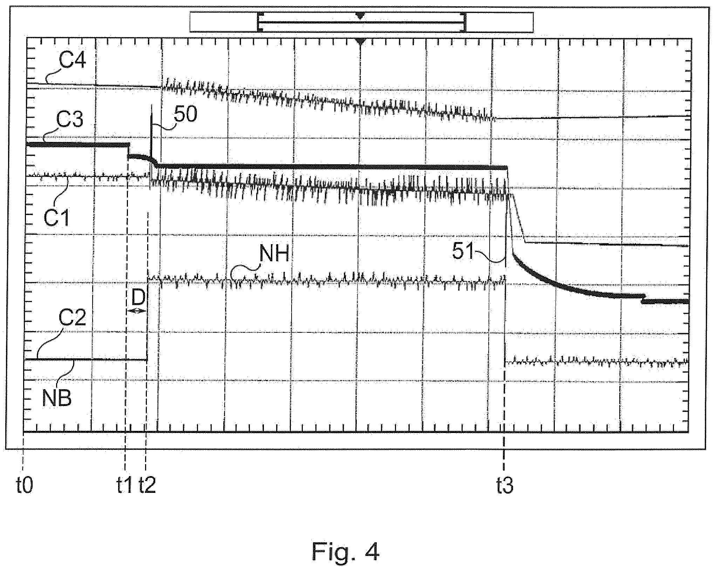

On illustre enfin, en référence à la figure 4, le fonctionnement du système d'alimentation selon l'invention 4. La courbe C1 représente la tension de niveau de charge Vnc sur le fil de contrôle 14. La courbe C2 représente la sortie de décharge SD. La courbe C3 représente la tension au niveau de la référence de tension d'alimentation 10. La courbe C4 représente un signal interne à l'unité de gestion de réserve 5 représentatif de la charge des moyens de stockage d'énergie 3.

A l'instant t0, la source d'alimentation principale 2 est disponible pour alimenter le module électrique 1 ainsi que l'unité de gestion principale 5 et l'unité de gestion de réserve 6. La référence de tension d'alimentation 10 de l'unité de gestion principale 5, visible sur la courbe C3, est donc égale à la tension d'alimentation principale Val.

Une coupure de la source d'alimentation principale 2 survient au moment t1. La référence de tension d'alimentation 10 diminue jusqu'au seuil d'alimentation prédéterminé.

Une impulsion de tension haute 50 est donc émise au temps t2 sur la tension de niveau de charge Vnc (courbe C1), ce qui active la décharge des moyens de stockage d'énergie 3 (la courbe C2 passe d'un niveau bas NB à un niveau haut NH). On note qu'une durée D de 0,5s sépare le temps t1 (coupure de la source d'alimentation principale 2) du temps t2 (activation de la décharge).

Lorsque la tension de niveau de charge Vnc devient, au temps t3, inférieure au seuil de tension de charge prédéterminé, une impulsion de tension basse 51 est émise sur la tension de niveau de charge Vnc, ce qui désactive la décharge des moyens de stockage d'énergie 3. La référence de tension d'alimentation 10 chute, l'unité de gestion de réserve 6 n'est plus alimentée, et la tension de niveau de charge Vnc sur le fil de contrôle 14 est annulée.

Bien entendu, l'invention n'est pas limitée au mode de réalisation décrit mais englobe toute variante entrant dans le champ de l'invention telle que définie par les revendications.

Bien que l'on ait ici positionné l'unité de gestion principale sur le module électrique, on pourrait très bien positionner l'unité de gestion principale sur une carte distincte ou dans un boîtier distinct du module électrique et même du concentrateur. L'unité de gestion de réserve, quant à elle, est ici située à proximité des moyens de stockage d'énergie, mais elle pourrait aussi être située sur une même carte électrique ou au sein d'un même boîtier que les moyens de stockage d'énergie.

## Revendications

1. Système d'alimentation comprenant une unité de gestion principale (5) destinée à être reliée à une source d'alimentation principale (2) et une unité de gestion de réserve (6) destinée à être reliée à des moyens de stockage d'énergie (3), l'unité de gestion principale et l'unité de gestion de réserve étant agencées pour être reliées l'une à l'autre par un fil de tension haute (13), un fil de tension basse (15) et un fil de contrôle (14), l'unité de gestion principale comportant des moyens d'application (21) adaptés à appliquer sélectivement une tension haute sur le fil de contrôle ou une tension basse sur le fil de contrôle pour transmettre à l'unité de gestion de réserve un signal d'activation de décharge ou un signal de désactivation de décharge, l'unité de gestion de réserve comportant des moyens de charge (26) adaptés à charger les moyens de stockage d'énergie via le fil de tension haute et le fil de tension basse, et des moyens de décharge (27) adaptés à décharger les moyens de stockage d'énergie via le fil de tension haute et le fil de tension basse lorsque l'unité de gestion de réserve reçoit le signal d'activation de décharge et à stopper la décharge lorsque l'unité de gestion de réserve reçoit le signal de désactivation de décharge.

2. Système d'alimentation selon la revendication 1, dans lequel l'unité de gestion principale (5) comporte un premier comparateur (23) destiné à comparer une tension (Val) de la source d'alimentation principale avec un seuil de tension d'alimentation prédéterminé, et à commander les moyens d'application (21) pour transmettre le signal d'activation de décharge si la tension de la source d'alimentation principale (2) est inférieure ou égale au seuil de tension d'alimentation prédéterminé.

3. Système d'alimentation selon la revendication 1, dans lequel l'unité de gestion de réserve comporte des moyens de conversion (29) destinés à convertir un niveau de charge des moyens de stockage d'énergie (3) en une tension de niveau de charge (Vnc) et à appliquer la tension de niveau de charge sur le fil de contrôle (14).

4. Système d'alimentation selon la revendication 3, dans lequel l'unité de gestion principale (5) comporte un deuxième comparateur (24) destiné à comparer la tension de niveau de charge (Vnc) avec un seuil de tension de charge prédéterminé, et à commander les moyens d'application (21) pour transmettre le signal de désactivation de décharge si la tension de niveau de charge est inférieure ou égale au seuil de tension de charge prédéterminé.

5. Système d'alimentation selon la revendication 4, dans lequel l'unité de gestion principale est adaptée à éteindre un module électrique (1) alimenté par la source d'alimentation principale et par le système d'alimentation lorsque la tension de niveau de charge est inférieure ou égale au seuil de tension de charge prédéterminé.

6. Système d'alimentation selon la revendication 1, dans lequel les moyens d'application (21) de l'unité de gestion principale comportent des composants de connexion adaptés à connecter sélectivement au fil de contrôle (14) une référence de tension d'alimentation (10) de l'unité de gestion principale reliée au fil de tension haute (13) et une référence de masse (11) de l'unité de gestion principale (5) reliée au fil de tension basse (15).

7. Système d'alimentation selon la revendication 6, dans lequel les composants de connexion de l'unité de gestion de réserve comportent un transistor de type MOSFET (30a, 30b).

8. Système d'alimentation selon la revendication 1, dans lequel l'unité de gestion de réserve comporte un gestionnaire d'état comprenant un circuit logique de type bascule D destiné à mémoriser un état logique représentatif d'un état de charge ou d'un état de décharge des moyens de stockage d'énergie.

9. Unité de gestion principale (5) destinée à être reliée à une source d'alimentation principale (2) et comportant :
- un connecteur comprenant une première broche (17) destinée à être connectée à un fil de tension haute (13), une deuxième broche (18) destinée à être connectée à un fil de contrôle (14), et une troisième broche (19) destinée à être connectée à un fil de tension basse (15), l'unité de gestion principale étant destinée à être connectée à une unité de gestion de réserve (6) par le fil de tension haute, le fil de contrôle et le fil de tension basse, l'unité de gestion de réserve (6) étant destinée à être reliée à des moyens de stockage d'énergie (3) ;
- des moyens d'application (21) adaptés à appliquer sélectivement une tension haute sur le fil de contrôle ou une tension basse sur le fil de contrôle pour transmettre à l'unité de gestion de réserve un signal d'activation de décharge ou un signal de désactivation de décharge.

10. Unité de gestion de réserve (6) destinée à être reliée à des moyens de stockage d'énergie (3) et comportant :
- un connecteur comprenant une première broche (17) destinée à être connectée à un fil de tension haute (13), une deuxième broche (18) destinée à être connectée à un fil de contrôle (14), et une troisième broche (19) destinée à être connectée à un fil de tension basse (15), l'unité de gestion de réserve étant destinée à être connectée à une unité de gestion principale par le fil de tension haute, le fil de contrôle et le fil de tension basse, l'unité de gestion principale étant destinée à être reliée à une source d'alimentation principale (2) ;
- des moyens de charge (26) adaptés à charger les moyens de stockage d'énergie via le fil de tension haute et le fil de tension basse ;
- des moyens de décharge (27) adaptés à décharger les moyens de stockage d'énergie via le fil de tension haute et le fil de tension basse lorsque l'unité de gestion de réserve reçoit un signal d'activation de décharge, et à stopper la décharge lorsque l'unité de gestion de réserve reçoit un signal de désactivation de décharge, le signal d'activation de décharge et le signal de désactivation de charge étant formés par une tension haute ou une tension basse appliquée sur le fil de contrôle par l'unité de gestion principale.

## Patentansprüche

1. Stromversorgungssystem, umfassend eine Hauptsteuereinheit (5), die dazu bestimmt ist, mit einer Hauptversorgungsquelle (2) verbunden zu werden, und eine Reservesteuereinheit (6), die dazu bestimmt ist, mit Energiespeichermitteln (3) verbunden zu werden, wobei die Hauptsteuereinheit und die Reservesteuereinheit ausgebildet sind, über einen Hochspannungsdraht (13), einen Niederspannungsdraht (15) und einen Steuerdraht (14) miteinander verbunden zu werden, wobei die Hauptsteuereinheit Anwendungsmittel (21) umfasst, die geeignet sind, selektiv eine Hochspannung an dem Steuerdraht oder eine Niederspannung an dem Steuerdraht anzulegen, um an die Reservesteuereinheit ein Entladungsaktivierungssignal oder ein Entladungsdeaktivierungssignal zu übertragen, wobei die Reservesteuereinheit Lademittel (26) umfasst, die geeignet sind, die Energiespeichermittel über den Hochspannungsdraht und den Niederspannungsdraht aufzuladen, und Entlademittel (27), die geeignet sind, die Energiespeichermittel über den Hochspannungsdraht und den Niederspannungsdraht zu entladen, wenn die Reservesteuereinheit das Entladungsaktivierungssignal empfängt, und die Entladung zu stoppen, wenn die Reservesteuereinheit das Entladungsdeaktivierungssignal empfängt.

2. Stromversorgungssystem nach Anspruch 1, bei dem die Hauptsteuereinheit (5) einen ersten Komparator (23) umfasst, der dazu bestimmt ist, eine Spannung (Val) der Hauptversorgungsquelle mit einem vorbestimmten Versorgungsspannungsschwellenwert zu vergleichen, und die Anwendungsmittel (21) zu steuern, um das Entladungsaktivierungssignal zu übertragen, wenn die Spannung der Hauptversorgungsquelle (2) niedriger oder gleich dem vorbestimmten Versorgungsspannungsschwellenwert ist.

3. Stromversorgungssystem nach Anspruch 1, bei dem die Reservesteuereinheit Umwandlungsmittel (29) umfasst, die dazu bestimmt sind, ein Ladeniveau der Energiespeichermittel (3) in eine Ladeniveauspannung (Vnc) umzuwandeln und die Ladeniveauspannung an dem Steuerdraht (14) anzulegen.

4. Stromversorgungssystem nach Anspruch 3, bei dem die Hauptsteuereinheit (5) einen zweiten Komparator (24) umfasst, der dazu bestimmt ist, die Ladeniveauspannung (Vnc) mit einem vorbestimmten Ladespannungsschwellenschwert zu vergleichen, und die Anwendungsmittel (21) zu steuern, um das Entladungsdeaktivierungssignal zu übertragen, wenn die Ladeniveauspannung niedriger oder gleich dem vorbestimmten Ladespannungsschwellenwert ist.

5. Stromversorgungssystem nach Anspruch 4, bei dem die Hauptsteuereinheit angepasst ist, ein von der Hauptversorgungsquelle und von dem Stromversorgungssystem versorgtes elektrisches Modul (1) abzuschalten, wenn die Ladeniveauspannung niedriger oder gleich dem vorbestimmten Ladespannungsschwellenwert ist.

6. Stromversorgungssystem nach Anspruch 1, bei dem die Anwendungsmittel (21) der Hauptsteuereinheit Verbindungskomponenten umfassen, die geeignet sind, mit dem Steuerdraht (14) selektiv eine Versorgungsspannungsreferenz (10) der Hauptsteuereinheit, die mit dem Hochspannungsdraht (13) verbunden ist, und eine Massenreferenz (11) der Hauptsteuereinheit (5), die mit dem Niederspannungsdraht (15) verbunden ist, zu verbinden.

7. Stromversorgungssystem nach Anspruch 6, bei dem die Verbindungskomponenten der Reservesteuereinheit einen Transistor vom Typ MOSFET (30a, 30b) umfassen.

8. Stromversorgungssystem nach Anspruch 1, bei dem die Reservesteuereinheit einen Zustandsmanager umfasst, der eine Logikschaltung vom Typ Kippschaltung D umfasst, die dazu bestimmt ist, einen Logikzustand, der repräsentativ für einen Ladezustand oder einen Entladezustand der Energiespeichermittel ist, zu speichern.

9. Hauptsteuereinheit (5), die dazu bestimmt ist, mit einer Hauptversorgungsquelle (2) verbunden zu werden, und die umfasst:
- einen Verbinder, der einen ersten Anschlussstift (17) umfasst, der dazu bestimmt ist, mit einem Hochspannungsdraht (13) verbunden zu werden, einen zweiten Anschlussstift (18), der dazu bestimmt ist, mit einem Steuerdraht (14) verbunden zu werden, und einen dritten Anschlussstift (19), der dazu bestimmt ist, mit einem Niederspannungsdraht (15) verbunden zu werden, wobei die Hauptsteuereinheit dazu bestimmt ist, über den Hochspannungsdraht, den Steuerdraht und den Niederspannungsdraht mit einer Reservesteuereinheit (6) verbunden zu werden, wobei die Reservesteuereinheit (6) dazu bestimmt ist, mit Energiespeichermitteln (3) verbunden zu werden;
- Anwendungsmittel (21), die geeignet sind, selektiv eine Hochspannung an dem Steuerdraht oder eine Niederspannung an dem Steuerdraht anzulegen, um an die Reservesteuereinheit ein Entladungsaktivierungssignal oder ein Entladungsdeaktivierungssignal zu übertragen.

10. Reservesteuereinheit (6), die dazu bestimmt ist, mit Energiespeichermitteln (3) verbunden zu werden, und die umfasst:
- einen Verbinder, der einen ersten Anschlussstift (17) umfasst, der dazu bestimmt ist, mit einem Hochspannungsdraht (13) verbunden zu werden, einen zweiten Anschlussstift (18), der dazu bestimmt ist, mit einem Steuerdraht (14) verbunden zu werden, und einen dritten Anschlussstift (19), der dazu bestimmt ist, mit einem Niederspannungsdraht (15) verbunden zu werden, wobei die Reservesteuereinheit dazu bestimmt ist, über den Hochspannungsdraht, den Steuerdraht und den Niederspannungsdraht mit einer Reservesteuereinheit (6) verbunden zu werden, wobei die Hauptsteuereinheit dazu bestimmt ist, mit einer Hauptversorgungsquelle (2) verbunden zu werden;
- Lademittel (26), die geeignet sind, die Energiespeichermittel über den Hochspannungsdraht und den Niederspannungsdraht zu laden;
- Entlademittel (27), die geeignet sind, die Energiespeichermittel über den Hochspannungsdraht und den Niederspannungsdraht zu entladen, wenn die Reservesteuereinheit ein Entladungsaktivierungssignal empfängt, und die Entladung zu stoppen, wenn die Reservesteuereinheit ein Entladungsdeaktivierungssignal empfängt, wobei das Entladungsaktivierungssignal und das Ladungsdeaktivierungssignal von einer Hochspannung oder einer Niederspannung gebildet werden, die an dem Steuerdraht von der Hauptsteuereinheit angelegt wird.

## Claims

1. A power supply system comprising a main management unit (5) intended to be connected to a main power source (2) and a reserve management unit (6) intended to be connected to energy storage means (3), the main management unit and the reserve management unit being arranged to be connected to each other by a high voltage wire (13), a low voltage wire (15) and a control wire (14), the main management unit comprising application means (21) suitable for selectively applying a high voltage to the control wire or a low voltage to the control wire in order to transmit a discharge activation signal or a discharge deactivation signal to the reserve management unit, the reserve management unit comprising charge means (26) suitable for charging the energy storage means through the high voltage wire and the low voltage wire, and discharge means (27) suitable for discharging the energy storage means through the high voltage wire and the low voltage wire when the reserve management unit receives the discharge activation signal and for stopping the discharge when the reserve management unit receives the discharge deactivation signal.

2. The power supply system according to claim 1, wherein the main management unit (5) comprises a first comparator (23) for comparing a voltage (Val) of the main power source with a predetermined power supply voltage threshold, and for controlling the application means (21) to transmit the discharge activation signal if the voltage of the main power source (2) is less than or equal to the predetermined power supply voltage threshold.

3. The power supply system according to claim 1, wherein the reserve management unit comprises conversion means (29) for converting a charge level of the energy storage means (3) into a charge level voltage (Vnc) and for applying the charge level voltage to the control wire (14).

4. The power supply system according to claim 3, wherein the main management unit (5) comprises a second comparator (24) for comparing the charge level voltage (Vnc) with a predetermined charge voltage threshold, and for controlling the application means (21) to transmit the discharge deactivation signal if the charge level voltage is less than or equal to the predetermined charge voltage threshold.

5. The power supply system according to claim 4, wherein the main management unit is intended to switch off an electrical module (1) powered by the main power source and by the power supply system when the load level voltage is less than or equal to the predetermined load voltage threshold.

6. The power supply system according to claim 1, wherein the application means (21) of the main management unit comprise connection components for selectively connecting to the control wire (14) a supply voltage reference (10) of the main management unit connected to the high voltage wire (13) and a ground reference (11) of the main management unit (5) connected to the low voltage wire (15) .

7. The power supply system according to claim 6, wherein the connection components of the reserve management unit comprise a transistor of MOSFET type (30a, 30b).

8. The power supply system according to claim 1, wherein the reserve management unit includes a state manager comprising a flip-flop-type logic circuit for storing a logic state representative of a state of charge or a state of discharge of the energy storage means.

9. A main management unit (5) intended to be connected to a main power source (2), and comprising:
- a connector comprising a first pin (17) intended to be connected to a high voltage wire (13), a second pin (18) intended to be connected to a control wire (14), and a third pin (19) intended to be connected to a low voltage wire (15), the main management unit being intended to be connected to a reserve management unit (6) through the high voltage wire, the control wire and the low voltage wire, the reserve management unit (6) being intended to be connected to energy storage means (3);
- application means (21) for selectively applying a high voltage to the control wire or a low voltage to the control wire to transmit to the reserve management unit a discharge activation signal or a discharge deactivation signal.

10. A reserve management unit (6) intended to be connected to energy storage means (3), and comprising:
- a connector comprising a first pin (17) intended to be connected to a high voltage wire (13), a second pin (18) intended to be connected to a control wire (14), and a third pin (19) intending to be connected to a low voltage wire (15), the reserve management unit being intended to be connected to a main management unit through the high voltage wire, the control wire and the low voltage wire, the main management unit being intended to be connected to a main power source (2);
- charge means (26) for charging the energy storage means through the high voltage wire and the low voltage wire;
- discharge means (27) for discharging the energy storage means through the high voltage wire and the low voltage wire when the reserve management unit receives a discharge activation signal, and for stopping the discharge when the reserve management unit receives a discharge deactivation signal, the discharge activation signal and the charge deactivation signal being formed by a high voltage or a low voltage applied to the control wire by the main management unit.
